# EUROPEAN PATENT SPECIFICATION

(11) **EP 3 375 606 B1**
(45) Date of publication and mention of the grant of the patent: **23.09.2020**
(21) Application number: 16864329.4
(22) Date of filing: 10.11.2016
(51) Int. Cl.: B32B 15/01, B05D 1/12, B05D 7/24, B32B 15/02, B32B 15/04, B32B 15/20, C04B 41/90, C22C 9/00, B32B 37/18, C23C 24/00

(54) **LAMINATE AND LAMINATE MANUFACTURING METHOD**
LAMINAT UND LAMINATHERSTELLUNGSVERFAHREN
STRATIFIÉ ET PROCÉDÉ DE FABRICATION DE STRATIFIÉ

(30) Priority: 11.11.2015 JP 2015221265
(43) Date of publication of application: 19.09.2018
(73) Proprietor: NHK Spring Co., Ltd., Yokohama-shi, Kanagawa 236-0004 (JP)
(72) Inventor: AIKAWA, Naoya, Isehara-shi Kanagawa 259-1126 (JP); HIRANO, Satoshi, Isehara-shi Kanagawa 259-1126 (JP); YAMAUCHI, Yuichiro, Yokohama-shi Kanagawa 236-0004 (JP)
(74) Representative: Hoffmann Eitle
(86) International application number: PCT/JP2016/083438
(87) International publication number: WO 2017/082368

(56) References cited:
- EP-A1- 2 695 972
- EP-A1- 2 732 967
- WO-A1-2014/157112
- WO-A1-2015/133351
- JP-A- S6 083 399
- JP-A- S6 083 399
- JP-A- 2010 001 543
- JP-A- 2011 068 942
- JP-A- 2011 068 942
- JP-A- 2012 111 982
- JP-A- 2013 018 190
- JP-A- 2015 168 846
- Rolf Sandström: "The role of hydrogen in copper", , 27 January 2014 (2014-01-27), XP055591514, Retrieved from the Internet: URL:http://www.skb.se/wp-content/uploads/2 015/05/1420051-PM-The-role-of-hydrogen-in- copper.pdf [retrieved on 2019-05-23]
- NAKAHARA S ET AL: "The hydrogen effect in copper", MATERIALS SCIENCE AND ENGINEERING: A, ELSEVIER, AMSTERDAM, NL, vol. 101, 1 May 1988 (1988-05-01), pages 227-230, XP025889075, ISSN: 0921-5093, DOI: 10.1016/0921-5093(88)90069-X [retrieved on 1988-05-01]

## Description

### Field

The present invention relates to a laminate obtained by laminating a metal film on a substrate and a method of manufacturing a laminate.

### Background

Hitherto, a power module is known as a key device for energy saving used in a wide field from power control for industry, automobiles, and the like to motor control. In the power module, a chip (transistor) is disposed on one surface of an insulating substrate (for example, a ceramic substrate) which is a substrate via a circuit pattern of a metal film, and a cooling unit is disposed on the other surface via the metal film (for example, refer to Patent Literature 1). As the cooling unit, for example, a unit in which a movement path of a heat medium for cooling is disposed in a member made of a metal or an alloy is used. Such a power module can perform cooling by moving heat generated from the chip to the cooling unit via the metal film and radiating the heat to an outside.

Examples of a method of manufacturing a laminate in which a metal film is formed on an insulating substrate include a thermal spraying method and a cold spraying method. The thermal spraying method is a method of forming a film by spraying a material (thermal spraying material) heated to a molten state or a state close thereto onto a substrate.

Meanwhile, the cold spraying method is a method of forming a film on a surface of a substrate by injecting a powder of a material from a divergent (laval) nozzle together with an inert gas at a melting point or lower or a softening point or lower, and causing the powder to collide with the substrate in a solid phase state (for example, refer to Patent Literature 2). In the cold spraying method, processing is performed at a lower temperature than the thermal spraying method, and therefore an influence of a thermal stress is alleviated. Therefore, it is possible to obtain a metal film without phase transformation and with suppressed oxidation. Particularly, in a case where materials of a substrate and a film are metals, when a powder of the metal material collides with the substrate (or a film formed previously), plastic deformation occurs between the powder and the substrate to obtain an anchor effect, oxide films thereof are broken, and metal bonding is generated by newly formed surfaces. As a result, a laminate having high adhesion strength can be obtained.

### Citation List

### Patent Literature

Patent Literature 1: JP 2011-108999 A
Patent Literature 2: JP 5548167 B2
Patent Literature 3: EP 2695972A1

Patent Literature 3 describes a substrate formed of a metal or alloy; an intermediate layer formed on a surface of the substrate and formed of a metal or alloy that is softer than the substrate; and a metal film deposited on a surface of the intermediate layer by accelerating a powder material of a metal or alloy together with a gas heated to a temperature lower than a melting point of the powder material and spraying the powder material onto the intermediate layer while keeping the powder material in a solid phase. The method disclosed in Patent Literature 3 consists of supplying a compressed gas to the powder supply apparatus, which supplies the material powder having a particle diameter of, for example, 10-100 µm. The heated compressed gas is made into a supersonic flow (> 340 m/s) through the gas nozzle. The material powder supplied to the spray gun is accelerated through introduction into the supersonic flow of the compressed gas to impinge on the substrate at high velocity while remaining in a solid phase to form a film.

### Summary

### Technical Problem

In the power module as described above, when the capacity of the chip is large, the amount of heat generation is also large. Therefore, it is important to quickly transfer generated heat to the cooling unit via a metal film or the like and to dissipate the heat. In order to improve heat transfer efficiency, a thicker metal film is more preferable because thermal resistance can be reduced. However, when the metal film is thick, in a case where a thermal load is applied to the power module, a risk of occurrence of a problem such as peeling of the metal film from the insulating substrate or cracking of the insulating substrate increases due to a difference in coefficient of thermal expansion between the metal film and the insulating substrate.

The present invention has been achieved in view of the above problems, and an object of the present invention is to provide a laminate having a high heat dissipation effect, having no problem such as cracking of an insulating substrate even when a thermal load is applied, and having no void or the like in a metal film, and a method of manufacturing the laminate.

### Solution to Problem

A laminate according to the present disclosure includes: an insulating substrate; an intermediate layer formed on a surface of the substrate and containing a metal or an alloy as a main component; and a metal film formed of a copper powder having a hydrogen content of 0.002% by mass or less and laminated on the intermediate layer, wherein an interface between the intermediate layer and the metal film is plastically deformed.

To solve the above-described problem and achieve the object, a laminate according to the present invention includes: a substrate made of a metal or an alloy; and a metal film formed of a copper powder having a hydrogen content of 0.002% by mass or less and laminated on the substrate, wherein an interface between the substrate and the metal film is plastically deformed.

Moreover, in the above-described laminate according to the present invention, the copper powder has an oxygen content of 0.03% by mass or more and 0.15% by mass or less.

Moreover, in the above-described laminate according to the present invention, the copper powder has a phosphorus content of 0.002% by mass or more and 0.028% by mass or less.

A method of manufacturing a laminate according to the present disclosure includes a film formation step of forming a metal film layer on a surface of an insulating substrate having an intermediate layer containing a metal or an alloy as a main component by accelerating a copper powder having a hydrogen content of 0.002% by mass or less together with a gas, and spraying and depositing the copper powder onto a surface of the intermediate layer in a solid phase state.

Moreover, a method of manufacturing a laminate according to the present invention includes a film formation step of forming a metal film layer on a surface of a substrate made of a metal or an alloy by accelerating a copper powder having a hydrogen content of 0.002% by mass or less together with a gas, and spraying and depositing the copper powder onto a surface of the substrate in a solid phase state.

Moreover, in the above-described method of manufacturing a laminate according to the present invention, the copper powder has an oxygen content of 0.03% by mass or more and 0.07% by mass or less.

Moreover, the above-described method of manufacturing a laminate according to the present invention includes a copper powder formation step of forming a copper powder by adding phosphorus or a phosphorus copper base metal to molten copper in an amount of 0.002% by mass or more and 0.028% by mass or less, and atomizing the resulting mixture.

Moreover, in the above-described method of manufacturing a laminate according to the present invention, the copper powder formation step does not include reduction heat treatment of a copper powder in a hydrogen atmosphere.

Moreover, in the above-described method of manufacturing a laminate according to the present invention, a copper powder is formed by a water atomizing method in the copper powder formation step.

Moreover, in the above-described method of manufacturing a laminate according to the present invention, a powderized copper powder is subjected to heat treatment in a vacuum atmosphere in the copper powder formation step.

Moreover, in the above-described method of manufacturing a laminate according to the present disclosure, the intermediate layer is formed by brazing a plate-shaped metal or alloy member to the substrate. Advantageous Effects of Invention

The present invention exhibits an effect of being able to obtain a laminate having a high heat dissipation effect, having no problem such as cracking of an insulating substrate even when a thermal load is applied, and having no void or the like in a metal film.

### Brief Description of Drawings

FIG. 1 is a schematic diagram illustrating a configuration of a power module that is a laminate according to the present disclosure and not in accordance with the claimed invention.
FIG. 2 is an enlarged cross-sectional view illustrating a main part of the laminate illustrated in FIG. 1.
FIG. 3 is a schematic diagram illustrating an outline of a cold spraying device.
FIG. 4 is a schematic diagram illustrating a configuration of a power module that is a laminate according to Modification Example 1 of the present disclosure.
FIG. 5 is a diagram for explaining a process of manufacturing each of laminates according to Examples (for reference and not according to the claimed invention) and Comparative Examples of the present description.
FIG. 6 is a graph illustrating thermal expansion characteristics when a thermal load is applied to each of the laminates according to Examples and Comparative Examples of the present description.

### Description of Embodiments

Hereinafter, an embodiment of the present invention will be described in detail with reference to the drawings. Note that the present invention is not limited by the following embodiment. In addition, in the drawings referred to in the following description, a shape, a size, and a positional relationship are only schematically illustrated such that the contents of the present invention can be understood. That is, the present invention is not limited only to the shape, the size, and the positional relationship illustrated in the drawings.

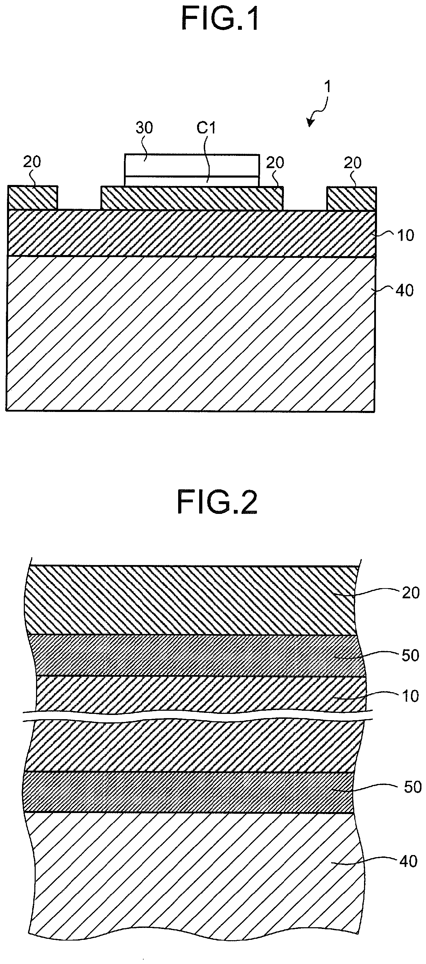

FIG. 1 is a schematic diagram illustrating a configuration of a power module that is a laminate according to the present disclosure. In addition, FIG. 2 is an enlarged cross-sectional view illustrating a main part of the laminate illustrated in FIG. 1. A power module 1 illustrated in FIG. 1 includes a ceramic substrate 10 that is an insulating substrate, a circuit layer 20 formed on one surface of the ceramic substrate 10, a chip 30 bonded onto the circuit layer 20 with solder C1, and a cooling fin 40 disposed on a surface of the ceramic substrate 10 opposite to the circuit layer 20.

The substrate 10 is a substantially plate-shaped member made of an insulating material. Examples of the insulating material include a nitride-based ceramic such as aluminum nitride or silicon nitride, an oxide-based ceramic such as alumina, magnesia, zirconia, steatite, forsterite, mullite, titania, silica, or sialon, and a resin layer including an inorganic filler.

The circuit layer 20 is a metal film layer formed by a cold spraying method described later, and is made of copper having a hydrogen content of 0.002% by mass or less. In this circuit layer 20, a circuit pattern for transmitting an electric signal to the chip 30 or the like is formed. By setting the hydrogen content of the metal film made of copper to 0.002% by mass or less, it is possible to prevent specific thermal expansion of the metal film due to release of hydrogen from the metal film when a thermal load is applied.

The chip 30 is realized by a semiconductor element such as a diode, a transistor, or an insulated gate bipolar transistor (IGBT). Note that a plurality of the chips 30 may be disposed on the substrate 10 according to a purpose of use.

The cooling fin 40 is made of a metal or an alloy having good thermal conductivity, such as copper, a copper alloy, aluminum, an aluminum alloy, silver, or a silver alloy. In addition to a cooling fin manufactured by casting, machining, or the like, a cooling fin manufactured by a cold spraying method described later can also be used. Heat generated from the chip 30 is released to an outside via the substrate 10 through the cooling fin 40 as described above.

As illustrated in FIG. 2, an intermediate layer 50 containing a metal or an alloy as a main component is disposed between the substrate 10 and the circuit layer 20 and between the substrate 10 and the cooling fin 40. The intermediate layer 50 is formed by bonding a plate-shaped metal or alloy member (hereinafter, collectively referred to as a metal member) to the substrate 10 using a brazing material.

The type of the brazing material can be selected according to the type of the substrate 10 or the type of the plate-shaped metal member. In the present disclosure, an aluminum brazing metal containing aluminum as a main component and containing at least one of germanium, magnesium, silicon, and copper, and a silver brazing metal containing silver as a main component, containing at least one of copper and tin, and containing titanium which is an active metal can be used.

In addition, as the plate-shaped metal member, a metal or an alloy having hardness that makes bonding to the substrate 10 by brazing possible and makes it possible to form a film by a cold spraying method is used. The range of the hardness varies depending on film formation conditions and the like in the cold spraying method, and therefore cannot be unconditionally determined, but generally a metal member having a Vickers hardness of 100 HV or less can be applied. Specific examples thereof include aluminum, silver, gold, copper, and an alloy containing these metals.

In the present disclosure, the circuit layer 20 formed on a surface of the intermediate layer 50 is made of copper having a hydrogen content of 0.002% by mass or less. In order to set the hydrogen content contained in copper forming the circuit layer 20 to 0.002% by mass or less, it is only required to form the circuit layer 20 using a copper powder having a hydrogen content of 0.002% by mass or less. As the copper powder having a hydrogen content of 0.002% by mass or less, it is only required to use a copper powder powderized by an atomizing method, preferably by a water atomizing method, and not subjected to reduction heat treatment in a hydrogen atmosphere.

Generally, a copper powder manufactured by the atomizing method is widely used as an electrically conductive material because an impurity concentration in the powder obtained can be smaller than that manufactured by a wet reduction method. The copper powder used as the electrically conductive material is subjected to reduction heat treatment in a hydrogen atmosphere, and further improves electric conductivity by reducing the content of oxygen contained in the powder. However, in a case where the circuit layer 20 which is a metal film is formed on the substrate 10 via the intermediate layer 50 using such a copper powder by a cold spraying method, and a thermal load is applied by connection of the chip 30 by the solder C1 or the like, the circuit layer 20 may be peeled off from the substrate 10, or cracking of the substrate 10, a void in the metal film (circuit layer 20), and the like may be generated. The present inventors studied a cause of cracking of the substrate 10 and the like and have found that thermal expansion specific to the circuit layer 20 which is a metal film layer occurs due to heat and that the thermal expansion specific to the circuit layer 20 occurs when hydrogen in the powder increased by reduction heat treatment of the copper powder in the hydrogen atmosphere is volatilized from the circuit layer 20 by heat. In the present disclosure, the circuit layer 20 is formed using the copper powder not subjected to reduction heat treatment in a hydrogen atmosphere. Therefore, peeling of the circuit layer 20 from the substrate 10 due to a thermal load, cracking of the substrate 10, generation of a void in the metal film (circuit layer 20) can be prevented.

In addition, the circuit layer 20 is formed at a low temperature by a cold spraying method. Therefore, an influence of a thermal stress is alleviated. Therefore, it is possible to obtain a metal film without phase transformation and with suppressed oxidation. Particularly, when a copper powder collides with the intermediate layer 50, plastic deformation occurs between the copper powder and a metal or alloy member which is a material of the intermediate layer 50 to obtain an anchor effect, oxide films thereof are broken, and metal bonding is generated by newly formed surfaces. As a result, a laminate having high adhesion strength can be obtained.

In the present disclosure, the oxygen content of the copper powder forming the circuit layer 20 is preferably 0.03% by mass or more and 0.15% by mass or less. By the oxygen content of the copper powder within the above range, electrical conductivity of the circuit layer 20 is improved, and the specific expansion of the circuit layer 20 due to a thermal load can be prevented.

In a case where the oxygen content of the copper powder is more than 0.07% by mass, the copper powder is preferably subjected to heat treatment in a vacuum atmosphere. The heat treatment is preferably performed at 400°C or higher and 800°C or lower for about one to two hours. Alternatively, by performing atomizing treatment or the like in a vacuum melting furnace, the oxygen content of the copper powder can be reduced. Incidentally, preferably, the copper powder used in the present disclosure is not subjected to reduction heat treatment in a hydrogen atmosphere. However, a copper powder which has been subjected to reduction heat treatment in a hydrogen atmosphere may be subjected to heat treatment in a vacuum atmosphere to make the hydrogen content 0.002% by mass or less and to make the oxygen content 0.03% by mass or more and 0.07% by mass or less for use.

In addition, in the copper powder, phosphorus or a phosphorus copper base metal may be added to molten copper for improvement of fluidity of the molten copper and deoxidization. By adding phosphorus, the content of oxygen can be reduced, and fluidity of the molten copper can be improved. However, as the amount of phosphorus added increases, residual elongation after thermal loading increases. Therefore, in a case where phosphorus is added to the copper powder, the phosphorus content in the copper powder is preferably 0.002% by mass or more and 0.028% by mass or less. By setting the phosphorus content in the copper powder within the above range, the residual elongation when a thermal load is applied to the circuit layer 20 can be suppressed. In addition, by setting the phosphorus content within the above range, recrystallization occurs in the circuit layer 20 due to heat generated when a film is formed by a cold spraying method, dislocation is reduced, and the circuit layer 20 having excellent thermal conductivity and electrical conductivity can be obtained. The phosphorus content in the copper powder is particularly preferably 0.005% by mass or more and 0.018% by mass or less.

A copper powder having an average particle diameter of 5 µm to 80 µm can be used. A copper powder having an average particle diameter of 20 µm to 50 µm is particularly preferable from a viewpoint of handleability and denseness of the circuit layer 20.

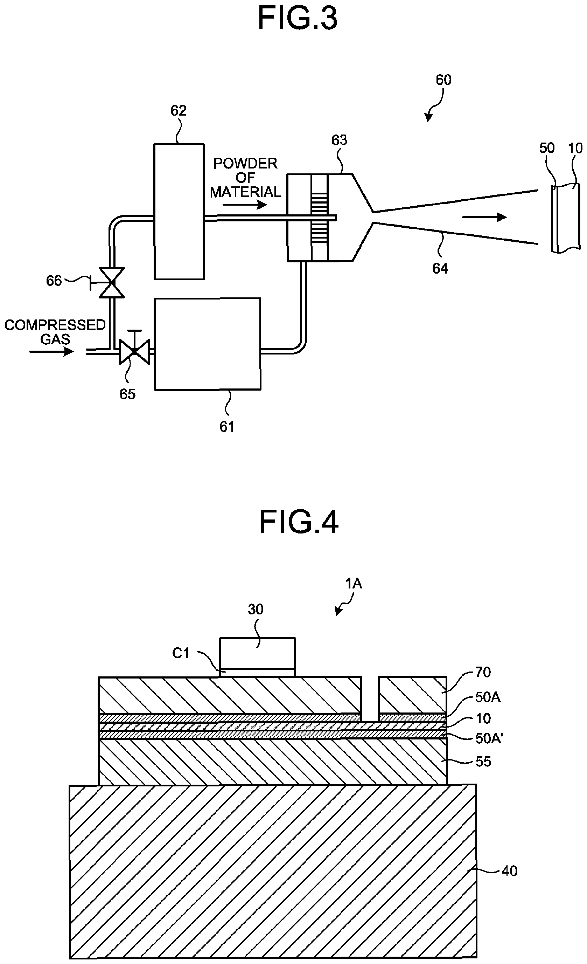

Next, a method of manufacturing the power module 1 will be described. FIG. 3 is a schematic diagram illustrating an outline of a cold spraying device.

First, the substrate 10 having the intermediate layer 50 formed on a surface thereof is prepared. The intermediate layer 50 can be formed by placing, on a surface of the substrate 10, an aluminum (Al)-based brazing material and a metallic foil such as aluminum (Al) or a silver-based brazing material and a metallic foil such as copper, and then performing heat treatment in vacuum.

A metal film layer serving as the circuit layer 20 is formed on the substrate 10 by accelerating a copper powder having a hydrogen content of 0.002% by mass or less together with a gas using a cold spraying device 60 illustrated in FIG. 3, and spraying and depositing the copper powder onto a surface of the intermediate layer 50 in a solid phase state.

The cold spraying device 60 includes a gas heater 61 for heating a compressed gas, a powder supply device 62 for housing a copper powder serving as a material of the circuit layer 20 and supplying the copper powder to a spray gun 63, a gas nozzle 64 for injecting the heated compressed gas and the material powder supplied thereto to a substrate, and valves 65 and 66 for adjusting the supply amounts of the compressed gas to the gas heater 61 and the powder supply device 62, respectively.

As the compressed gas, helium, nitrogen, air, or the like is used. A compressed gas supplied to the gas heater 61 is heated to a temperature in a range lower than the melting point of the copper powder serving as a material of the circuit layer 20, for example, 50°C or higher, and then supplied to the spray gun 63. The heating temperature of the compressed gas is preferably 300 to 900°C. Meanwhile, the compressed gas supplied to the powder supply device 62 supplies the copper powder in the powder supply device 62 to the spray gun 63 so as to have a predetermined discharge amount.

The heated compressed gas is formed into a supersonic flow (about 340 m/s or more) by the gas nozzle 64 having a divergent shape. The gas pressure of the compressed gas at this time is preferably about 1 to 5 MPa. This is because adhesion strength of the circuit layer 20 to the intermediate layer 50 can be improved by adjusting the pressure of the compressed gas to such a degree. The treatment is more preferably performed at a pressure of about 2 to 4 MPa. The copper powder supplied to the spray gun 63 is accelerated by injection of the compressed gas into the supersonic flow, collides with the intermediate layer 50 on the substrate 10 at high speed in a solid phase state, and is deposited to form a metal film. Note that a device is not limited to the cold spraying device 60 illustrated in FIG. 3 as long as being able to form a film by causing a material powder to collide with the substrate 10 in a solid phase state. It is only required to form the circuit layer 20 by disposing a metal mask or the like having a circuit pattern formed on an upper layer of the intermediate layer 50.

The cooling fin 40 cut into a desired shape may be bonded to a surface of the substrate 10 opposite to a surface on which the circuit layer 20 is formed with a heat transfer sheet, grease, or the like. Alternatively, the cooling fin 40 may be obtained by forming a film (deposition layer) of a desired thickness, for example, using an aluminum powder, with the cold spraying device 60, and then forming a desired flow path pattern on this film (deposition layer) by laser cutting or the like.

According to the disclosure described above, the circuit layer 20 is formed by the cold spraying method using a copper powder having a hydrogen content of 0.002% by mass or less. Therefore, it is possible to obtain the power module 1 having no problem such as cracking of the substrate 10 due to specific thermal expansion even when a thermal load is applied, and having no void or the like in the circuit layer 20. In addition, the circuit layer 20 is formed on a surface of the substrate 10 via the intermediate layer 50, and therefore the circuit layer 20 having excellent adhesion can be obtained.

Note that the laminate of the present disclosure can also be applied to a power module illustrated in FIG. 4. FIG. 4 is a schematic diagram illustrating a configuration of a power module according to Modification Example 1 of the present disclosure.

A power module 1A according to Modification Example 1 illustrated in FIG. 4 includes a substrate 10, an intermediate layer 50A formed on one surface of the substrate 10, an intermediate layer 50A' formed on the other surface of the substrate 10, a buffer layer 55 formed on a surface of the intermediate layer 50A', a thermal diffusion layer 70 formed on a surface of the intermediate layer 50A, a chip 30 disposed on the thermal diffusion layer 70 via the solder C1, and a cooling fin 40 disposed on the buffer layer 55 via a heat transfer sheet (not illustrated).

The intermediate layer 50A is made of a metal having good electric conductivity, such as copper, and is bonded to the substrate 10 via a brazing material. The intermediate layer 50A also functions as a circuit layer, and a circuit pattern of the intermediate layer 50A is formed by etching or the like.

The intermediate layer 50A' is made of a metal having good electric conductivity, such as copper, and is bonded to the substrate 10 via a brazing material. The intermediate layer 50A' transfers heat generated in the chip 30 and the intermediate layer 50A to the buffer layer 55 and the cooling fin 40.

The thermal diffusion layer 70 is a metal film directly formed on the intermediate layer 50A by a cold spraying method using a copper powder having a hydrogen content of 0.002% by mass or less. The thermal diffusion layer 70 can reduce thermal resistance by diffusing the heat generated in the chip 30 not only in a thickness direction of the substrate 10 but also in a plane orthogonal to the thickness direction.

The buffer layer 55 is formed of a material having high thermal conductivity and a coefficient of thermal expansion which is intermediate between the substrate 10 and a material used for the cooling fin 40. Examples thereof include a composite material containing copper and any metal selected from the group consisting of an iron nickel alloy, titanium, chromium, tungsten, and molybdenum (hereinafter, also referred to as an additive) and a composite material containing aluminum and any metal selected from the group consisting of copper, nickel, an iron nickel alloy, titanium, chromium, tungsten, and molybdenum (hereinafter, also referred to as an additive). The buffer layer 55 is formed directly on a surface of the intermediate layer 50A' by a cold spraying method.

The buffer layer 55 has a good heat transfer property for efficiently conducting heat generated in the chip 30 and the intermediate layer 50A to the cooling fin 40 and a low coefficient of thermal expansion for alleviating a thermal stress in the substrate 10. Specifically, the buffer layer 55 preferably has thermal conductivity of 75 W/mK or more and 220 W/mK or less, and preferably has a coefficient of thermal expansion (CTE) of 7.1 × 10⁻⁶/K or more and 11 × 10⁻⁶/K or less.

Although depending on the area of a region where the chip 30 is mounted, the thickness of the thermal diffusion layer 70 is preferably about 0.5 mm to 1.5 mm. In addition, in relation to the buffer layer 55, the thickness of the thermal diffusion layer 70 is preferably 1/2 times or more and 1 time or less the thickness of the buffer layer 55.

According to Modification Example 1 of the present disclosure, the thermal diffusion layer 70 is disposed between the intermediate layer 50A and the chip 30 using a copper powder having a hydrogen content of 0.002% by mass or less by a cold spraying method. Therefore, it is possible to reduce thermal resistance in the intermediate layer 50A and the substrate 10 and to alleviate a thermal stress applied to the substrate 10. In addition, the buffer layer 55 is formed on a surface of the intermediate layer 50A' by a cold spraying method, and therefore the thermal stress applied to the substrate 10 can be further alleviated. Furthermore, by adjusting a material constituting the buffer layer 55, a good heat transfer property in the buffer layer 55 can be maintained. Therefore, it is possible to efficiently release heat generated in the chip 30 and the intermediate layer 50A to an outside via the cooling fin 40, and to realize the power module 1A having excellent durability.

Note that the power module has been described as an example in the above disclosure. According to the present invention a metal film is directly formed on a substrate made of a metal or an alloy. A laminate obtained by forming a metal film on a substrate made of a metal or an alloy by accelerating a copper powder having a hydrogen content of 0.002% by mass or less together with a gas using the cold spraying device 60, and spraying and depositing the copper powder onto a surface of the substrate in a solid phase state has a small hydrogen content in the copper powder constituting the metal film, and therefore has fewer voids in the metal film and excellent thermal conductivity, electrical conductivity, and strength. Examples

By the method of manufacturing a laminate according to the present disclosure, a laminate having a copper film with a hydrogen content of a predetermined value or less formed on a substrate was manufactured. Thermal expansion/contraction characteristics of the copper film after heat treatment, a void thereof, cracking of the laminate, and the like were evaluated. As the substrate, an AMC substrate in which a metallic foil serving as an intermediate layer was pasted on both surfaces of a silicon nitride substrate via a brazing material was used.

### (Example 1)(not according to the invention)

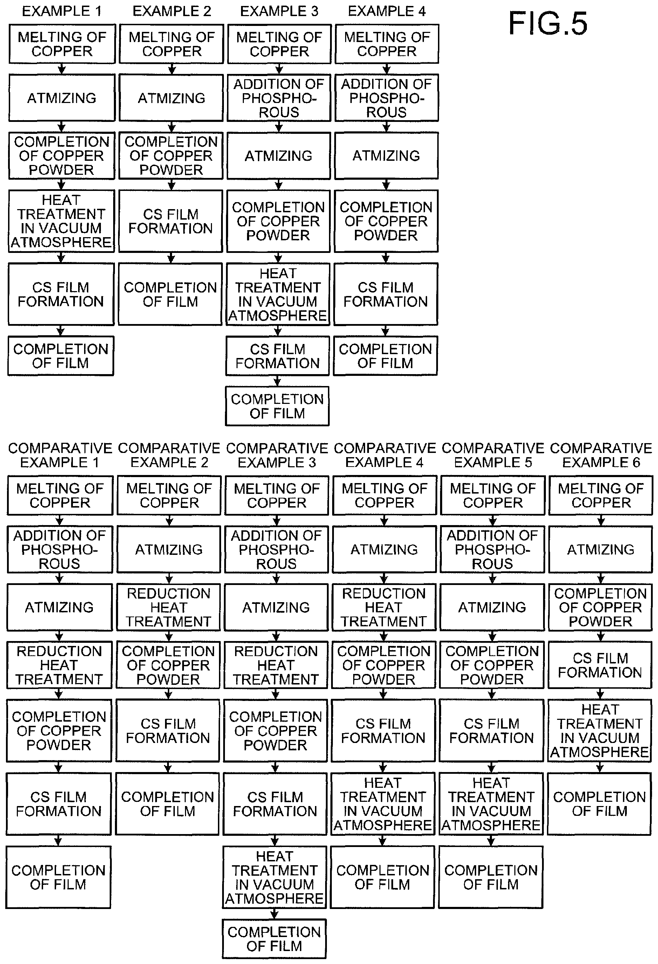

A metal film was formed on an AMC substrate (insulating substrate: silicon nitride (thickness 0.32 mm), intermediate layer: pure copper (thickness 0.5 mm)) by a process illustrated as Example 1 in FIG. 5. A copper powder was obtained by melting copper into molten copper, then forming a copper powder having an average particle diameter of about 35 µm by a water atomizing method, and subjecting the copper powder to heat treatment at 600°C for two hours in a vacuum atmosphere. The copper powder had a hydrogen content of 0.002% by mass or less. The metal film was formed by spraying the copper powder thus prepared onto the AMC substrate using the cold spraying device 60 under conditions of working gas: nitrogen, working gas temperature: 800°C, working gas pressure: 3 MPa, working distance (WD): 25 mm, traverse speed: 200 mm/s, and pass number: one time.

### (Example 2) (not according to the invention)

A metal film was formed on an AMC substrate (insulating substrate: silicon nitride (thickness 0.32 mm), intermediate layer: pure copper (thickness 0.5 mm)) by a process illustrated as Example 2 in FIG. 5. A copper powder was obtained by melting copper into molten copper, and then forming a copper powder having an average particle diameter of about 35 µm by a water atomizing method. The copper powder had a hydrogen content of 0.002% by mass or less. Spraying conditions for the metal film using the cold spraying device 60 are similar to those in Example 1.

### (Example 3) (not according to the invention)

A metal film was formed on an AMC substrate (insulating substrate: silicon nitride (thickness 0.32 mm), intermediate layer: pure copper (thickness 0.5 mm)) by a process illustrated as Example 3 in FIG. 5. A copper powder was obtained by melting copper into molten copper, then adding phosphorus so as to have a phosphorus content of 0.006% by mass, forming a copper powder having an average particle diameter of about 35 µm by a water atomizing method, and subjecting the copper powder to heat treatment at 600°C for two hours in a vacuum atmosphere. The copper powder had a hydrogen content of 0.002% by mass or less. Spraying conditions for the metal film using the cold spraying device 60 are similar to those in Example 1.

### (Example 4) (not according to the invention)

A metal film was formed on an AMC substrate (insulating substrate: silicon nitride (thickness 0.32 mm), intermediate layer: pure copper (thickness 0.5 mm)) by a process illustrated as Example 4 in FIG. 5. A copper powder was obtained by melting copper into molten copper, then adding phosphorus so as to have a phosphorus content of 0.006% by mass, and forming a copper powder having an average particle diameter of about 35 µm by a water atomizing method. The copper powder had a hydrogen content of 0.002% by mass or less. Spraying conditions for the metal film using the cold spraying device 60 are similar to those in Example 1.

### (Comparative Example 1)

A metal film was formed on an AMC substrate (insulating substrate: silicon nitride (thickness 0.32 mm), intermediate layer: pure copper (thickness 0.5 mm)) by a process illustrated as Comparative Example 1 in FIG. 5. A copper powder was obtained by melting copper into molten copper, then adding phosphorus so as to have a phosphorus content of 0.01% by mass, forming a copper powder having an average particle diameter of about 35 µm by a water atomizing method, and subjecting the copper powder to reduction heat treatment at 400°C for one hour in a hydrogen atmosphere. The copper powder had a hydrogen content of 0.01% by mass and an oxygen content of 0.07% by mass. Spraying conditions for the metal film using the cold spraying device 60 are similar to those in Example 1.

### (Comparative Example 2)

A metal film was formed on an AMC substrate (insulating substrate: silicon nitride (thickness 0.32 mm), intermediate layer: pure copper (thickness 0.5 mm)) by a process illustrated as Comparative Example 2 in FIG. 5. A copper powder was obtained by melting copper into molten copper, then forming a copper powder having an average particle diameter of about 35 µm by a water atomizing method without adding phosphorus, subjecting the copper powder to reduction heat treatment at 400°C for one hour in a hydrogen atmosphere, and then further subjecting the copper powder to reduction heat treatment at 700°C for one hour. The copper powder had a hydrogen content of 0.005% by mass and an oxygen content of 0.07% by mass. Spraying conditions for the metal film using the cold spraying device 60 are similar to those in Example 1.

### (Comparative Example 3)

A metal film was formed on an AMC substrate (insulating substrate: silicon nitride (thickness 0.32 mm), intermediate layer: pure copper (thickness 0.5 mm)) by a process illustrated as Comparative Example 3 in FIG. 5. A copper powder was obtained by melting copper into molten copper, then adding phosphorus so as to have a phosphorus content of 0.01% by mass, forming a copper powder having an average particle diameter of about 35 µm by a water atomizing method, and subjecting the copper powder to reduction heat treatment at 400°C for one hour in a hydrogen atmosphere. The copper powder had a hydrogen content of 0.01% by mass and an oxygen content of 0.07% by mass. In Comparative Example 3, a metal film was formed using this copper powder with the cold spraying device 60 in a similar manner to Example 1, and then the metal film was subjected to heat treatment at 600°C for two hours in a vacuum atmosphere.

### (Comparative Example 4)

A metal film was formed on an AMC substrate (insulating substrate: silicon nitride (thickness 0.32 mm), intermediate layer: pure copper (thickness 0.5 mm)) by a process illustrated as Comparative Example 4 in FIG. 5. A copper powder was obtained by melting copper into molten copper, then forming a copper powder having an average particle diameter of about 35 µm by a water atomizing method without adding phosphorus, subjecting the copper powder to reduction heat treatment at 400°C for one hour in a hydrogen atmosphere, and then further subjecting the copper powder to reduction heat treatment at 700°C for one hour. The copper powder had a hydrogen content of 0.005% by mass and an oxygen content of 0.07% by mass. In Comparative Example 4, a metal film was formed using this copper powder with the cold spraying device 60 in a similar manner to Example 1, and then the metal film was subjected to heat treatment at 600°C for two hours in a vacuum atmosphere.

### (Comparative Example 5)

A metal film was formed on an AMC substrate (insulating substrate: silicon nitride (thickness 0.32 mm), intermediate layer: pure copper (thickness 0.5 mm)) by a process illustrated as Comparative Example 5 in FIG. 5. A copper powder was obtained by melting copper into molten copper, then adding phosphorus so as to have a phosphorus content of 0.01% by mass, and forming a copper powder having an average particle diameter of about 35 µm by a water atomizing method. The copper powder had a hydrogen content of 0.001% by mass and an oxygen content of 0.14% by mass. In Comparative Example 5, a metal film was formed using this copper powder with the cold spraying device 60 in a similar manner to Example 1, and then the metal film was subjected to heat treatment at 600°C for two hours in a vacuum atmosphere.

### (Comparative Example 6)

A metal film was formed on an AMC substrate (insulating substrate: silicon nitride (thickness 0.32 mm), intermediate layer: pure copper (thickness 0.5 mm)) by a process illustrated as Comparative Example 6 in FIG. 5. A copper powder was obtained by melting copper into molten copper, and then forming a copper powder having an average particle diameter of about 35 µm by a water atomizing method without adding phosphorus. The copper powder had a hydrogen content of 0.001% by mass and an oxygen content of 0.15% by mass. In Comparative Example 6, a metal film was formed using this copper powder with the cold spraying device 60 in a similar manner to Example 1, and then the metal film was subjected to heat treatment at 600°C for two hours in a vacuum atmosphere.

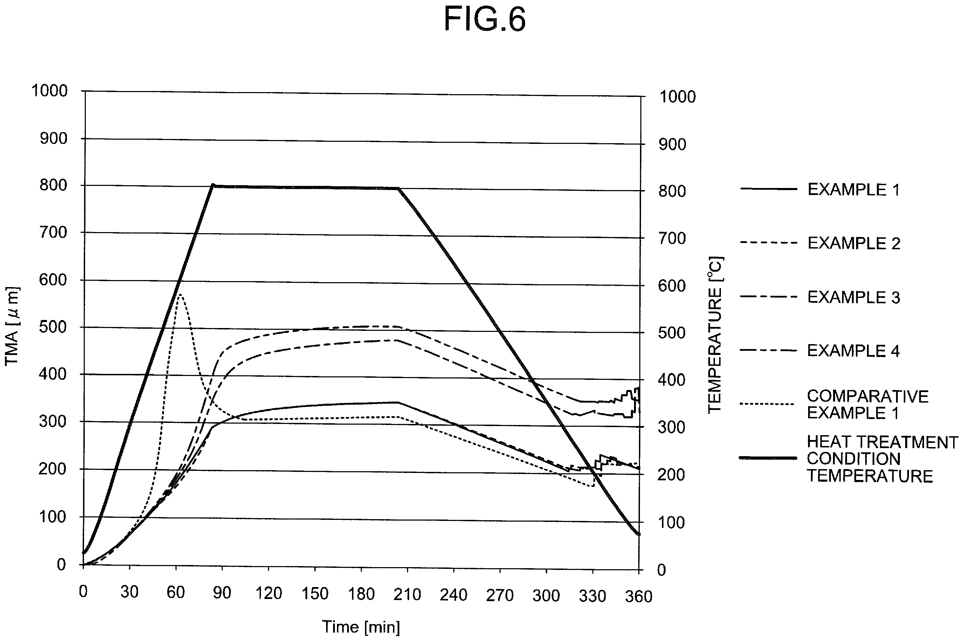

Table 1 summarizes characteristics of metal films in the laminates of Examples 1 to 4 and Comparative Examples 1 to 6, thermal expansion/contraction characteristics of the metal films after heat treatment, voids thereof, cracking of substrates, peeling of the films, and the like. In addition, FIG. 6 illustrates a correlation between time of heat treatment and elongation (TMA) of a metal film in each of the laminates of Examples 1 to 4 and Comparative Example 1. In the graph of FIG. 6, the scale on the left indicates elongation (TMA, µm) of a metal film, the scale on the right indicates a temperature (°C), and a solid line illustrated in the graph indicates a heat treatment condition. In the heat treatment, temperature was raised to 800°C at 10°C/min, was held at 800°C for 120 minutes, and then was lowered to 75°C at 5°C/min. Note that TMA was measured with a TMA measuring apparatus ThermoPlus TG 8120 manufactured by Rigaku Corporation by cutting out a metal film of 5 mm × 5 mm × 15 mm from a laminate.

**Table 1**

| | Characteristic of metal film | | | Metal film after heat treatment | | Laminate |
|---|---|---|---|---|---|---|
| | Hydrogen content | Oxygen content | Impurity | Expansion/Contraction | Void | Cracking/Peeling |
| Example 1* | small | large | small | not occurred | hardly generate d | not occurred |
| Example 2^{*} | small | large | small | not occurred | hardly generated | not occurred |
| Example 3* | small | large | large | not occurred | slightly generated | not occurred |
| Example 4* | small | large | large | not occurred | slightly generated | not occurred |
| Comparative Example 1 | large | small | large | occurred | a lot generated | occurred |
| Comparative Example 2 | large | small | small | occurred | a lot generated | occurred |
| Comparative Example 3 | small | small | large | occurred | a lot generated | occurred |
| Comparative Example 4 | small | small | small | occurred | a lot generated | occurred |
| Comparative Example 5 | small | large | large | not occurred | slightly generated | occurred |
| Comparative Example 6 | small | large | small | not occurred | hardly generated | occurred |

| | | | | | | |
|---|---|---|---|---|---|---|
| *not according to the present invention | | | | | | |

As illustrated in Table 1, in Examples 1 to 4 and Comparative Examples 5 and 6 in which reduction heat treatment was not performed in a hydrogen atmosphere, and in Comparative Examples 3 and 4 in which a metal film was formed using a copper powder which had been subjected to reduction heat treatment in a hydrogen atmosphere, and heat treatment was performed in a vacuum atmosphere after the film formation, the hydrogen content in a metal film was low. When a laminate is subjected to heat treatment, the hydrogen content in a metal film is low in Examples 1 to 4. Therefore, specific thermal expansion/contraction does not occur, and peeling of a metal film or cracking of a substrate does not occur. In Examples 1 and 2 in which phosphorus was not added, a void in a metal film was hardly observed. In Examples 3 and 4 in which phosphorus was added, a few voids were generated, thermal expansion of a metal film was larger than that in Examples 1 and 2, and residual elongation was large also after cooling.

In Comparative Examples 1 and 2 in which a copper powder was subjected to reduction heat treatment in a hydrogen atmosphere, the hydrogen content in a metal film was large. Therefore, specific thermal expansion/contraction (expansion and contraction of a metal film occurring in 60 to 90 minutes in Comparative Example 1 in FIG. 6) occurred, and cracking occurred in a substrate of a laminate due to this specific expansion/contraction.

In Comparative Examples 3 and 4, a metal film was formed with a copper powder which had been subjected to reduction heat treatment in a hydrogen atmosphere. However, heat treatment was performed in a vacuum atmosphere after the metal film was formed, and therefore the hydrogen content in the metal film was small. However, many voids were generated when hydrogen was released from the metal film by the heat treatment after the film formation, and the heat treatment was performed after a laminate was formed. As a result, cracking of a substrate occurred easily.

As described above, the laminate and the method of manufacturing the laminate according to the present invention are useful for obtaining a laminate preventing occurrence of cracking or the like of an insulating substrate and having no void in a metal film.

### Reference Signs List

- 1, 1A: Power module
- 10: Substrate
- 20: Circuit layer
- 30: Chip
- 40: Cooling fin
- 50, 50A, 50A': Intermediate layer
- 55: Buffer layer
- 70: Thermal diffusion layer
- 60: Cold spraying device
- 61: Gas heater
- 62: Powder supply device
- 63: Spray gun
- 64: Gas nozzle
- 65, 66: Valve

## Claims

1. A laminate comprising:
a substrate (10) made of a metal or an alloy; and
a metal film (20, 70) formed of a copper powder having a hydrogen content of 0.002% by mass or less, an oxygen content of 0.03% by mass or more and 0.15% by mass or less, and a phosphorus content of 0.002% by mass or more and 0.028% by mass or less; and laminated on the substrate (10) ,
wherein an interface between the substrate (10) and the metal film (20, 70) is plastically deformed.

2. A method of manufacturing a laminate, comprising a film formation step of forming a metal film (20, 70)layer on a surface of a substrate (10) made of a metal or an alloy by accelerating a copper powder having a hydrogen content of 0.002% by mass or less together with a gas, and spraying and depositing the copper powder onto a surface of the substrate (10) in a solid phase state,
wherein the copper powder has an oxygen content of 0.03% by mass or more and 0.07% by mass or less;
wherein the method of manufacturing the laminate further comprises a copper powder formation step of forming a copper powder by adding phosphorus or a phosphorus copper base metal to molten copper in an amount of 0.002% by mass or more and 0.028% by mass or less, and atomizing the resulting mixture.

3. The method of manufacturing a laminate according to claim 2, wherein the copper powder formation step does not include reduction heat treatment of a copper powder in a hydrogen atmosphere.

4. The method of manufacturing a laminate according to claim 2 or 3, wherein a copper powder is formed by a water atomizing method in the copper powder formation step.

5. The method of manufacturing a laminate according to any one of claims 2 to 4, wherein a powderized copper powder is subjected to heat treatment in a vacuum atmosphere in the copper powder formation step.

## Patentansprüche

1. Laminat, umfassend:
ein Substrat (10), das aus einem Metall oder einer Legierung hergestellt ist; und
einen Metallfilm (20, 70), der aus einem Kupferpulver mit einem Wasserstoffgehalt von 0,002 Massen-% oder weniger, einem Sauerstoffgehalt von 0,03 Massen-% oder mehr und 0,15 Massen-% oder weniger und einem Phosphorgehalt von 0,002 Massen-% oder mehr und 0,028 Massen-% oder weniger gebildet ist; und auf das Substrat (10) laminiert ist,
wobei eine Grenzfläche zwischen dem Substrat (10) und dem Metallfilm (20, 70) plastisch verformt ist.

2. Verfahren zur Herstellung eines Laminats, umfassend einen Filmbildungsschritt, bei dem eine Metallfilmschicht (20, 70) auf einer Oberfläche eines Substrats (10), das aus einem Metall oder einer Legierung hergestellt ist, gebildet wird, indem ein Kupferpulver mit einem Wasserstoffgehalt von 0,002 Massen-% oder weniger zusammen mit einem Gas beschleunigt wird, und das Kupferpulver in einem Festphasenzustand auf eine Oberfläche des Substrats (10) gesprüht und abgeschieden wird,
wobei das Kupferpulver einen Sauerstoffgehalt von 0,03 Massen-% oder mehr und 0,07 Massen-% oder weniger aufweist;
wobei das Verfahren zur Herstellung des Laminats ferner einen Kupferpulverbildungsschritt umfasst, bei dem ein Kupferpulver gebildet wird, indem Phosphor oder ein Phosphor-Kupferbasismetall in einer Menge von 0,002 Massen-% oder mehr und 0,028 Massen-% oder weniger zu geschmolzenem Kupfer gegeben wird und die resultierende Mischung zerstäubt wird.

3. Verfahren zur Herstellung eines Laminats gemäß Anspruch 2, wobei der Kupferpulverbildungsschritt nicht einschließt, dass ein Kupferpulver in einer Wasserstoffatmosphäre reduktionswärmebehandelt wird.

4. Verfahren zur Herstellung eines Laminats gemäß Anspruch 2 oder 3, wobei bei dem Kupferpulverbildungsschritt ein Kupferpulver durch ein Wasserzerstäubungsverfahren gebildet wird.

5. Verfahren zur Herstellung eines Laminats gemäß einem der Ansprüche 2 bis 4, wobei bei dem Kupferpulverbildungsschritt ein pulverisiertes Kupferpulver in einer Vakuumatmosphäre wärmebehandelt wird.

## Revendications

1. Stratifié comprenant :
un substrat (10) fait d'un métal ou d'un alliage ; et
un film métallique (20, 70) formé d'une poudre de cuivre présentant une teneur en hydrogène de 0,002 % en masse ou moins, une teneur en oxygène de 0,03 % en masse ou plus et de 0,15 % en masse ou moins, et une teneur en phosphore de 0,002 % en masse ou plus et de 0,028 % en masse ou moins ; et stratifié sur le substrat (10),
dans lequel une interface entre le substrat (10) et le film métallique (20, 70) est déformée plastiquement.

2. Procédé de fabrication d'un stratifié, comprenant une étape de formation de film consistant à former une couche de film métallique (20, 70) sur une surface d'un substrat (10) fait d'un métal ou d'un alliage en accélérant une poudre de cuivre présentant une teneur en hydrogène de 0,002 % en masse ou moins avec un gaz, et en pulvérisant et en déposant la poudre de cuivre sur une surface du substrat (10) dans un état en phase solide,
dans lequel la poudre de cuivre présente une teneur en oxygène de 0,03 % en masse ou plus et de 0,07 % en masse ou moins ;
dans lequel le procédé de fabrication du stratifié comprend en outre une étape de formation de poudre de cuivre consistant à former une poudre de cuivre en ajoutant du phosphore ou un métal à base de phosphore et de cuivre à du cuivre fondu dans une quantité de 0,002 % en masse ou plus et de 0,028 % en masse ou moins, et en atomisant le mélange résultant.

3. Procédé de fabrication d'un stratifié selon la revendication 2, dans lequel l'étape de formation de poudre de cuivre n'inclut pas de traitement thermique de réduction d'une poudre de cuivre dans une atmosphère d'hydrogène.

4. Procédé de fabrication d'un stratifié selon la revendication 2 ou 3, dans lequel une poudre de cuivre est formée par un procédé d'atomisation d'eau dans l'étape de formation de poudre de cuivre.

5. Procédé de fabrication d'un stratifié selon l'une quelconque des revendications 2 à 4, dans lequel une poudre de cuivre pulvérulente est soumise à un traitement thermique dans une atmosphère sous vide dans l'étape de formation de poudre de cuivre.
